# EUROPÄISCHE PATENTSCHRIFT

(11) **EP 2 638 183 B1**
(45) Veröffentlichungstag und Bekanntmachung des Hinweises auf die Patenterteilung: **06.12.2017**
(21) Anmeldenummer: 11779137.6
(22) Anmeldetag: 26.10.2011
(51) Int. Cl.: C23C 18/12

(54) **VERFAHREN ZUR HERSTELLUNG VON INDIUMOXID-HALTIGEN SCHICHTEN**
PROCESS FOR PREPARING COATINGS CONTAINING INDIUM OXIDE
PROCÉDÉ POUR LA PRÉPARATION DE COUCHES CONTENANT DE L'OXYDE D'INDIUM

(30) Priorität: 10.11.2010 DE 102010043668
(43) Veröffentlichungstag der Anmeldung: 18.09.2013
(73) Patentinhaber: Evonik Degussa GmbH, 45128 Essen (DE)
(72) Erfinder: STEIGER, Jürgen, 40237 Düsseldorf (DE); PHAM, Duy Vu, 46047 Oberhausen (DE); THIEM, Heiko, 64625 Bensheim (DE); MERKULOV, Alexey, 67059 Ludwigshafen (DE); HOPPE, Arne, 44623 Herne (DE)
(86) Internationale Anmeldenummer: PCT/EP2011/068736
(87) Internationale Veröffentlichungsnummer: WO 2012/062575

(56) Entgegenhaltungen:
- DE-B3-102009 054 997

## Beschreibung

Die vorliegende Erfindung betrifft ein Verfahren zur Herstellung von Indiumoxid-haltigen Schichten, die mit dem erfindungsgemäßen Verfahren herstellbaren Indiumoxid-haltigen Schichten sowie deren Verwendung.

Die Herstellung halbleitender elektronischer Bauteilschichten über Druck- und andere flüssige Abscheidungsprozesse ermöglicht im Vergleich zu vielen anderen Verfahren, wie z.B. Chemical Vapor Deposition (CVD), eine prozesstechnische Vereinfachung und weitaus niedrigere Produktionskosten, da die Deposition des Halbleiters hier in einem kontinuierlichen Prozess erfolgen kann. Darüber hinaus eröffnet sich im Falle niedrigerer Prozesstemperaturen die Möglichkeit, auch auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 1 bis 50 cm²/Vs bei einem Bauteil mit einer Kanallänge von 20 µm bei 50 V Gate-Source-Spannung und 50 V Source-Drain-Spannung aufweisen.

Da das Material der über Druck oder andere flüssige Abscheidungsverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiterschichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, In₂O₃) ist aufgrund der großen Bandlücke zwischen 3.6 und 3.75 eV (gemessen für aufgedampfte Schichten, H.S. Kim, P.D. Byrne, A. Facchetti, T.J. Marks; J. Am. Chem. Soc. 2008, 130, 12580-12581) ein vielversprechender und somit gerne eingesetzter Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 cm²/Vs messen. Bislang können jedoch solche Werte durch Prozessierung aus Lösung noch nicht erreicht werden (H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513).

Indiumoxid wird oft zusammen mit Zinn(IV)-oxid (SnO₂) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxid-haltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches oder dispergierbares Vorprodukt nach dem Verdrucken einer entsprechenden Zusammensetzung zu einer Indiumoxid-haltigen Schicht umgesetzt wird. Unter einem Precursor ist dabei eine thermisch oder mit elektromagnetischer Strahlung zersetzbare Verbindung, mit der in An- oder Abwesenheit von Sauerstoff oder anderen Oxidationsstoffen Metalloxid-haltige Schichten gebildet werden können, zu verstehen. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursoren für die Herstellung von Indiumoxid-Schichten. So können neben Indiumsalzen auch Indium-Alkoxide (homoleptische, d.h. nur Indium und Alkoxid-Reste aufweisende Verbindungen, insbesondere Indiumverbindungen des Typs In(OR)₃ mit R = Alkyl- bzw. Oxyalkylrest) und Indium-Halogen-Alkoxide (d.h. sowohl Halogen- als auch Alkoxidreste aufweisende Indiumverbindungen, insbesondere dreiwertige Indiumverbindungen des Typs InXₘ(OR)₃₋ₘ mit X = Halogen, R = Alkyl- bzw. Oxyalkylrest und m = 1,2) als Precursoren für die Herstellung von Indiumoxid-haltigen Schichten eingesetzt werden.

Zum Beispiel beschreiben Marks et al. Bauteile, bei deren Herstellung eine Precursor-haltige Zusammensetzung umfassend das Salz InCl₃ sowie der Base Monoethanolamin (MEA) gelöst in Methoxyethanol eingesetzt wird. Nach Aufschleudern (Spin-coating) der Zusammensetzung wird die entsprechende Indiumoxid-Schicht durch eine thermische Behandlung bei 400 °C erzeugt (H.S. Kim, P.D. Byrne, A. Facchetti, T.J. Marks; J. Am. Chem. Soc. 2008, 130, 12580-12581 and supplemental informations).

Gegenüber Indiumsalz-haltigen Zusammensetzungen bieten Indiumalkoxid- bzw. Indium-Halogen-Alkoxid-haltige Zusammensetzungen den Vorteil, dass sie bei geringeren Temperaturen zu Indiumoxid-haltigen Beschichtungen umgewandelt werden können. Weiterhin wurde bislang davon ausgegangen, dass halogenhaltige Precursoren potentiell den Nachteil haben, zu halogenhaltigen Schichten mit verminderter Qualität zu führen. Aus diesem Grund wurden in der Vergangenheit Versuche zur Schichtbildung mit Indiumalkoxiden vorgenommen.

Indium-Alkoxide sowie Indium-Halogen-Alkoxide und ihre Synthese sind bereits seit den siebziger Jahren des vorigen Jahrhunderts beschrieben.

So fassen zum Beispiel Carmalt et al. in einem Review-Artikel die zu diesem Zeitpunkt bekannten Daten zu Synthese, Struktur und Reaktivitäten von u.a. Indium(III)alkoxiden und - alkylalkoxiden zusammen (Carmalt et al., Coord. Chem Rev. 250 (2006), 682 - 709).

Eine der am längsten bekannten Synthesen von Indiumalkoxiden beschreiben Chatterjee et al. Sie beschreiben die Herstellung von Indiumtrisalkoxid In(OR)₃ aus Indium(III)chlorid (InCl₃) mit Natriumalkoxid NaOR, wobei R für -Methyl, -Ethyl, iso-Propyl, n-, s-, t-Butyl und -Pentyl Reste steht (S. Chatterjee, S. R. Bindal, R.C. Mehrotra; J. Indian Chem. Soc.1976, 53, 867).

Bradley et al. berichten von einer ähnlichen Reaktion wie Chatterjee et al. und erhalten bei annähernd identischen Edukten (InCl₃, Isopropyl-Natrium) und Reaktionsbedingungen einen Indium-Oxo-Alkoxid-Cluster mit Sauerstoff als Zentralatom (D.C. Bradley, H. Chudzynska, D.M. Frigo, M.E. Hammond, M.B. Hursthouse, M.A. Mazid; Polyhedron 1990, 9, 719).

Eine besonders gute Variante dieses Verfahrens, die zu einer besonders niedrigen Verunreinigung an Chlor im Produkt führt, wird in US 2009-0112012 A1 beschrieben. Die Bestrebungen, einen möglichst niedrigen Grad an Chlor-Verunreinigungen im Produkt zu erreichen, werden dabei darauf zurückgeführt, dass bislang davon ausgegangen wurde, dass Chlor-Verunreinigungen zu einer Verminderung der Performance oder der Lebensdauer elektronischer Bauteile beitragen (vergleiche zum Beispiel US 6,426,425 B2).

Ebenfalls auf einem Indiumhalogenid, jedoch auf anderen Basen, basiert das in US 5,237,081 A beschriebene Verfahren zur Herstellung reiner Indiumalkoxide, bei dem ein Indium(III)halogenid in einem basischen Medium mit einem Alkohol umgesetzt wird. Die Base soll eine starke Base mit niedriger Nucleophilie sein. Beispielhaft genannte Basen sind neben exemplarisch genannten komplexen cyclischen Heterocyclen tertiäre Amine.

Alternative Syntheserouten zu homoleptischen Indiumalkoxid-Komplexen werden von Seigi Suh et al. in J. Am. Chem. Soc. 2000, 122, 9396 - 9404 beschrieben. Die dort beschriebenen Verfahren sind jedoch sehr aufwändig und/oder basieren auf nicht kommerziell erhältlichen (und somit erst nachteilig in einem vorgelagerten Schritt zu synthetisierenden) Edukten.

Ein allgemeines Verfahren zur Herstellung von Halogen-Alkoxy-Metall-Verbindungen ist in US 4,681,959 A beschrieben: Dort wird allgemein ein zweistufiges Verfahren zur Herstellung von Metallalkoxiden (insbesondere von Tetraalkoxyverbindungen wie Tetramethyltitanat) beschrieben, bei dem ein Halogenid eines mindestens zweiwertigen Metalls mit einem Alkohol - ggf. in Gegenwart eines aromatischen Lösemittels - zunächst zu einem Zwischenprodukt (einer Halogen-Alkoxy-Verbindung des Metalls) umgesetzt wird. Bevorzugt wird dabei entstehender Halogenwasserstoff mit einem Inertgas wie z.B. Stickstoff ausgetrieben.

Indiumhalogenalkoxide und ihre Synthese sind auch in JP 02-113033 A und JP 02-145459 A beschrieben. So offenbart JP 02-113033 A, dass chlorhaltige Alkoxide von Indium nach Lösung von Indiumchlorid in einem dem einzubauenden Alkoxidrest entsprechenden Alkohol durch nachfolgende Zugabe eines bestimmten Anteils eines Alkalimetalls oder einer Alkalimetallalkoxids hergestellt werden können. Ein entsprechendes Verfahren beschreibt auch JP 02-145459 A.

Die Herstellung von Indiumoxid-haltigen Schichten aus Indiumalkoxiden und Indium-Halogen-Alkoxiden kann prinzipiell i) durch Sol-Gel-Prozesse, bei denen die eingesetzten Precursoren in Gegenwart von Wasser durch Hydrolyse und nachfolgende Kondensation zunächst zu Gelen reagieren und dann in Metalloxide konvertiert werden, oder ii) aus nichtwässriger Lösung erfolgen. Die Konvertierung zu Indiumoxid-haltigen Schichten kann dabei thermisch und/oder durch elektromagnetische Strahlung erfolgen.

Verfahren zur Herstellung Indiumoxid-haltiger Schichten mit thermischer Konvertierung gehören dabei zum Stand der Technik. WO 2008/083310 A1 beschreibt zum Beispiel Verfahren zur Herstellung anorganischer Schichten bzw. organischer/anorganischer Hybridschichten auf einem Substrat, bei dem ein Metallalkoxid (z.B. eines der generischen Formel R¹M (OR²)_{y-x}) oder ein Präpolymer davon auf ein Substrat aufgebracht und dann die resultierende Metallalkoxid-Schicht in Gegenwart von und Reaktion mit Wasser unter Zufuhr von Wärme ausgehärtet wird. Bei den einsetzbaren Metallalkoxiden kann es sich u.a. um ein Indiumalkoxid handeln. Nach der Konvertierung kann eine nachfolgende Behandlung der erhaltenen Schicht mit Wärme oder UV erfolgen.

Auch JP 01-115010 A befasst sich mit einer thermischen Konvertierung bei einem Sol-Gel-Prozess. In diesem Dokument werden Zusammensetzungen für transparente, leitende dünne Schichten beschrieben, die eine lange Topfzeit haben, als Zusammensetzung nicht hydrolysieren, und die chlorhaltige Indiumalkoxide der Formel In(OR)ₓCl₃₋ₓ aufweisen. Diese Zusammensetzungen können nach dem Aufbringen auf ein Substrat, Gelierung des Alkoxids auf dem Substrat durch den Wasseranteil in Luft, nachfolgende Trocknung bei bis zu 200 °C bei Temperaturen von 400 - 600 °C konvertiert werden.

JP 02-113033 A beschreibt Verfahren zum Aufbringen einer antistatischen Beschichtung auf ein nicht-metallisches Material, bei dem das nicht-metallische Material mit einer Zusammensetzung umfassend ein chlorhaltiges Indium-Alkoxid beschichtet, die Zusammensetzung an Luft geliert und nachfolgend calciniert wird.

JP 2007-042689 A beschreibt Metallalkoxid-Lösungen, die Indiumalkoxide enthalten können, sowie Verfahren zur Herstellung von Halbleiterbauelementen, die diese Metallalkoxid-Lösungen einsetzen. Die Metallalkoxid-Lösungen können über eine thermische Behandlung zur OxidSchicht umgewandelt werden.

JP 02-145459 A beschreibt Indium-Halogen-Alkoxid-haltige Beschichtungszusammensetzungen, die bei Lagerung nicht hydrolysieren und die durch Calcinierung in eine Indiumoxid-haltige Schicht umgewandelt werden können.

JP 59-198607 A beschreibt Verfahren zur Herstellung transparenter leitender Schichten, die einen Schutzfilm aus verschiedenen Harzen aufweisen können. Die transparente leitende Schicht kann eine Indiumoxid-haltige Schicht sein, und kann über ein Flüssigphasenverfahren hergestellt werden, bei dem eine entsprechende Zusammensetzung auf ein Substrat aufgebracht, getrocknet und thermisch konvertiert wird. Gemäß den Beispielen kann eine InCl(OC₃H₇)₂ enthaltende Zusammensetzung eingesetzt werden.

JP 59-198606 A beschreibt Zusammensetzungen zur Bildung transparenter elektrisch leitender Schichten, die InClₓ(OR)₃₋ₓ und ein organisches Lösemittel aufweisen und einen Wasseranteil von 0,1 - 10 % bezogen auf das organische Lösemittel haben. Somit handelt es sich bei dieser Zusammensetzung um ein Sol eines Indium-Halogen-Alkoxids. Zur Bildung der transparenten leitenden Schicht wird die Zusammensetzung nach Aufbringen auf ein Substrat und Trocknung bei typischerweise 150 °C bei Temperaturen von bevorzugt 300 °C gebrannt.

Eine rein thermisch durchgeführte Konvertierung hat jedoch den Nachteil, dass mit ihr keine feinen Strukturen hergestellt werden können und dass weiterhin keine präzise Steuerung der resultierenden Schichteigenschaften möglich ist.

Aus diesem Grund wurden Verfahren zur Konvertierung zu Indiumoxid-haltigen Schichten entwickelt, die auf dem Einsatz elektromagnetischer Strahlung (insbesondere von UV-Strahlung) beruhen.

So beschreibt JP 09-157855 A ein Sol-Gel-Verfahren zur Herstellung einer Metalloxid-Schicht, bei dem ein durch Hydrolyse hergestelltes Metalloxid-Sol aus einem Metallalkoxid oder einem Metallsalz (z.B. einem Indiumalkoxid oder -salz) auf die Oberfläche eines Substrats gebracht wird, ggf. bei einer Temperatur, bei der das Gel noch nicht kristallisiert, getrocknet wird und mit UV-Strahlung von weniger als 360 nm bestrahlt wird.

Ausschließlich über Strahlung erfolgende Konvertierungen haben jedoch den Nachteil, dass sie über eine längere Zeit sehr hohe Energiedichten erfordern und insofern apparativ sehr aufwändig sind. Aus diesem Grund wurden Verfahren, die nicht nur auf thermischer Konvertierung, sondern auch auf Konvertierung mit elektromagnetischer Strahlung beruhen, entwickeln.

JP 2000-016812 A beschreibt ein Verfahren zur Herstellung einer Metalloxidschicht über ein Sol-Gel-Verfahren. Bei diesem wird das Substrat mit einer Beschichtungszusammensetzung eines Metall-Oxid-Sols aus einem Metallsalz oder Metallalkoxid, insbesondere einer In₂O₃-SnO₂-Zusammensetzung, beschichtet und mit UV-Strahlung einer Wellenlänge kleiner als 360 nm bestrahlt und wärmebehandelt.

JP 11-106935 A beschreibt ein Verfahren zur Herstellung eines Oxid-basierten transparenten leitenden Films, bei dem u.a. eine wasserfreie Zusammensetzung umfassend ein Alkoxid eines Metalls (z.B. Indium) auf ein Substrat aufgebracht und erhitzt wird. Der Film kann weiterhin anschließend mit UV- oder VIS-Strahlung konvertiert werden in eine Metalloxid-basierte Dünnschicht.

Die DE 10 2009 054 997 beschreibt Flüssigphasenverfahren zur Herstellung Indiumoxid-haltiger Schichten aus nichwässriger Lösung, bei denen eine wasserfreie Zusammensetzung enthaltend mindestens ein Lösemittel bzw. Dispersionsmedium und mindestens ein Precursor der Formel InX(OR)₂ in wasserfreier Atmosphäre auf ein Substrat aufgebracht, mit elektromagnetischer Strahlung < 360 nm bestrahlt und thermisch konvertiert wird.

Die bekannten Verfahren zur Herstellung Indiumoxid-haltiger Schichten über kombinierte thermische Konvertierung und Konvertierung mit elektromagnetischer Strahlung weisen jedoch den Nachteil auf, dass der Einsatz der in der Literatur ausführlich beschriebenen Indiumalkoxide deutlich schlechtere halbleitende Eigenschaften aufweist. Weiterhin führt selbst die Kombination thermischer Konvertierung mit einer Konvertierung mittels elektromagnetischer bzw. UV-Strahlung allein nicht zu ausreichend zufriedenstellenden Ergebnissen, insbesondere in Bezug auf die resultierenden Felddeffektbeweglichkeiten µFET.

Es stellt sich somit die Aufgabe, die geschilderten Nachteile des Standes der Technik zu überwinden und ein verbessertes Verfahren zur Herstellung Indiumoxid-haltiger Schichten bereitzustellen.

Diese Aufgabe wird erfindungsgemäß gelöst durch das Flüssigphasen-Verfahren zur Herstellung Indiumoxid-haltiger Schichten gemäß Anspruch 1, bei dem eine aus einem Gemisch enthaltend mindestens einen Indiumoxid-Precursor und mindestens ein Lösemittel bzw. Dispersionsmedium herstellbare Beschichtungszusammensetzung in der Reihenfolge der Punkte a) bis d)
a) auf ein Substrat aufgebracht,
b) die auf dem Substrat aufgebrachte Zusammensetzung mit elektromagnetischer Strahlung bestrahlt,
c) ggf. getrocknet und
d) thermisch in eine Indiumoxid-haltige Schicht konvertiert wird,
bei dem
- der Indiumoxid-Precursor ein Indium-Halogen-Alkoxid der generischen Formel InX(OR)₂ mit R = Alkylrest und/oder Alkoxyalkylrest und X = F, Cl, Br oder I ist und
- die Bestrahlung mit elektromagnetischer Strahlung mit signifikanten Anteilen von Strahlung im Bereich von 170 - 210 nm und von 250 - 258 nm durchgeführt wird.

Bei dem erfindungsgemäßen Flüssigphasen-Verfahren zur Herstellung Indiumoxid-haltiger Schichten handelt es sich um ein Verfahren umfassend mindestens einen Verfahrensschritt, bei dem das zu beschichtende Substrat mit einer flüssigen Beschichtungszusammensetzung auf Basis mindestens eines Indium-Halogen-Alkoxids der generischen Formel InX(OR)₂ mit R = Alkylrest und/oder Alkoxyalkylrest und X = F, Cl, Br oder I beschichtet, mit elektromagnetischer Strahlung bestrahlt, ggf. nachfolgend getrocknet und anschließend thermisch konvertiert wird. Insbesondere handelt es sich bei diesem Prozess nicht um einen Sputter- oder CVD-Prozess. Unter flüssigen Zusammensetzungen im Sinne der vorliegenden Erfindung sind solche zu verstehen, die bei SATP-Bedingungen ("Standard Ambient Temperature and Pressure"; T = 25 °C und p = 1013 hPa) und bei Aufbringen auf das zu beschichtende Substrat flüssig vorliegen.

Unter einer aus einem Gemisch enthaltend den mindestens einen Indiumoxid-Precursor der generischen Formel InX(OR)₂ herstellbaren Beschichtungszusammensetzung sind dabei sowohl Beschichtungszusammensetzungen enthaltend den Precursor InX(OR)₂ als auch Beschichtungszusammensetzungen enthaltend (ggf. in Ergänzung zu InX(OR)₂) aus InX(OR)₂ im Gemisch mit dem mindestens einen Lösemittel bzw. Dispersionsmedium herstellbare Indium-Oxo-Alkoxide oder Indium-Halogen-Oxo-Alkoxide (insbesondere solche der generischen Formeln In₇O₂(OH)(OR)₁₂X₄(ROH)ₓ oder In₆O₂X₆(OR)₆(R'CH(O)COOR")₂(HOR)ₓ(HNR"'₂)_{y}) zu verstehen. Bevorzugt wird das erfindungsgemäße Verfahren jedoch mit Beschichtungszusammensetzungen enthaltend InX(OR)₂ durchgeführt.

Unter dem Verfahrensprodukt des erfindungsgemäßen Verfahrens, der Indiumoxid-haltigen Schicht, ist eine metall- bzw. halbmetallhaltige Schicht zu verstehen, die Indiumatome bzw.-ionen aufweist, die im Wesentlichen oxidisch vorliegen. Gegebenenfalls kann die Indiumoxid-haltige Schicht auch noch Stickstoff- (aus der Reaktion), Kohlenstoff- (insbesondere Carben-), Halogen- und/oder Alkoxid-Anteile aus einer nicht vollständigen Konvertierung oder einer unvollständigen Entfernung entstehender Nebenprodukte aufweisen. Die Indiumoxid-haltige Schicht kann dabei eine reine Indiumoxid-Schicht sein, d.h. bei Nichtberücksichtigung etwaiger Stickstoff-, Kohlenstoff- (insbesondere Carben-), Alkoxid- oder Halogen-Anteile im Wesentlichen aus oxidisch vorliegenden Indiumatomen bzw. -ionen bestehen, oder anteilig noch weitere Metalle, Halbmetalle oder Nichtmetalle, die selbst in elementarer oder oxidischer Form vorliegen können, aufweisen. Zur Erzeugung reiner Indiumoxid-Schichten sollten bei dem erfindungsgemäßen Verfahren nur Indium-Halogen-Alkoxide, bevorzugt nur ein Indium-Halogen-Alkoxid, eingesetzt werden. Im Gegensatz dazu sind zur Erzeugung auch andere Metalle, Halbmetalle und/oder Nichtmetalle aufweisender Schichten neben den Indium-Halogen-Alkoxiden auch Precursoren dieser Elemente in der Oxidationsstufe 0 (zur Herstellung von Schichten enthaltend weitere Metalle in neutraler Form) bzw. Sauerstoff-haltige Precursoren enthaltend die Elemente in positiver Oxidationsstufe (wie z.B. andere Metallalkoxide oder Metallhalogenalkoxide) einzusetzen.

Überraschenderweise wurde weiterhin festgestellt, dass die bisherige Annahme, dass halogenhaltige Precursoren zwangsläufig zu nachteiligen Schichten führen, nicht immer zutrifft. So resultieren bei dem erfindungsgemäßen Verfahren, bei dem eine flüssige Indiumoxid-Precursor-Zusammensetzung auf ein Substrat aufgebracht wird und der Beschichtungsfilm vor einer thermischen Konvertierung zunächst mit UV-Strahlung behandelt wird, aufgrund der Verwendung von Indiumchlordialkoxiden anstelle von Indiumalkoxiden sogar bessere Schichten, da diese bessere elektrische Eigenschaften, insbesondere eine höhere Feldeffektbeweglichkeit aufweisen Weiterhin können im Falle der Verwendung von Indiumhalogendialkoxiden anstelle von Indiumalkoxiden weiterhin überraschenderweise amorphere Schichten erzielt werden. Amorphe Schichten besitzen gegenüber einer Schicht aus einzelnen Nanokristallen den Vorteil einer größeren Homogenität, was sich ebenfalls in besseren elektrischen Eigenschaften, insbesondere homogeneren Feldeffektbeweglichkeiten auf größeren Substraten, bemerkbar macht.

Die Bestrahlung mit elektromagnetischer Strahlung erfolgt erfindungsgemäß mit elektromagnetischer Strahlung mit signifikanten Anteilen von Strahlung im Bereich von 170 - 210 nm und von 250 - 258 nm. Dabei ist unter Strahlung "mit signifikanten Anteilen von Strahlung im Bereich von 170 - 210 nm und von 250 - 258 nm" Strahlung zu verstehen, deren für diese beiden Wellenlängenbereiche summarisch bestimmte Intensität bezogen auf die zu bestrahlende Probe mindestens 5 mW/cm² beträgt, mit der Maßgabe, dass dabei auf den intensitätsschwächeren der beiden Bereiche immer eine auf das Substrat bezogene Intensität von mindestens 0,5 mW/cm² entfällt. Die absoluten Werte können mit verschiedenen im Handel befindlichen Apparaturen direkt und wellenlängenabhängig gemessen werden. Als Beispiel kann das "UV Power Meter C9536" von der Firma Hamamatsu genannt werden.

Bevorzugt, weil dies zu besonders guten Werten für µ_{FET} führt, erfolgt die Bestrahlung mit elektromagnetischer Strahlung mit signifikanten Anteilen von Strahlung im Bereich von 183 - 187 nm und von 250 - 258 nm, wobei wiederum ein entsprechendes Verständnis des Begriffs "mit signifikanten Anteilen" zu Grunde zu legen ist (die für diese beiden Wellenlängenbereiche summarisch bestimmte Intensität bezogen auf die zu bestrahlende Probe beträgt mindestens 5 mW/cm², mit der Maßgabe, dass auf den intensitätsschwächeren der beiden Bereiche immer eine auf das Substrat bezogene Intensität von mindestens 0,5 mW/cm² entfällt.

Besonders gute Ergebnisse werden weiterhin erzielt, wenn die Strahlung mit signifikanten Anteilen von Strahlung im Bereich von 170 - 210 nm und von 250 - 258 nm, noch weiter bevorzugt entsprechende Strahlung mit signifikanten Anteilen im Bereich von 183 - 187 nm und von 250 - 258 nm, in einem hinsichtlich beider Achsen jeweils linear skalierten Intensitäts-Wellenlänge-Spektrum über die gesamte Emission der Lampe mindestens 85 % ihrer Intensität (ermittelt über den prozentualen Anteil der Summe der Integrale der Teilbereiche an der als Integral über alle Wellenlängen des Spektrums ermittelten Gesamtintensität der Strahlung) innerhalb der beiden jeweils genannten Bereichen aufweist.

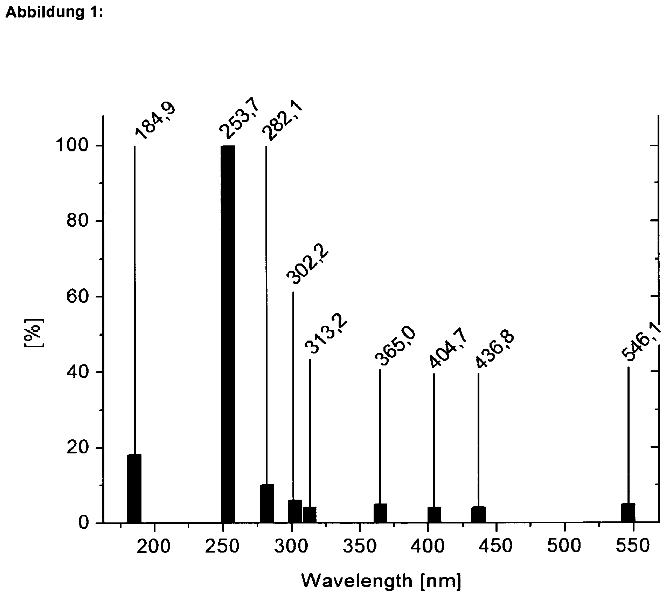

Entsprechende Strahlung mit signifikanten Anteilen von Strahlung im Bereich von 170 - 210 nm und von 250 - 258 nm kann bevorzugt durch Verwendung von Niederdruck-Quecksilberdampflampen, insbesondere Quarzglas-Niederdruck-Quecksilberdampflampen, erzeugt werden. Eine besonders bevorzugt einsetzbare Quarzglas-Niederdruck-Quecksilberdampflampe ist eine mit dem Leuchtmittel GLF-100 versehene, unter der Handelsbezeichnung Model 144AX-220 erhältliche Lampe der Firma Jelight Company, Inc, deren Spektrum in Abbildung 1 dargestellt wird.

Die erfindungsgemäß einzusetzenden Indiumoxid-Precursoren InX(OR)₂ weisen bevorzugt Alkyl- bzw. Alkyloxyalkylreste R ausgewählt aus der Gruppe der C1- bis C15-Alkyl- oder Alkyloxyalkylgruppen auf, d.h. Alkyl- oder Alkyloxyalkylgruppen mit insgesamt 1 - 15 Kohlenstoffatomen. Bevorzugt handelt es sich um Alkyl- bzw. Alkyloxyalkylreste R ausgewählt aus -CH₃, -CH₂CH₃, -CH₂CH₂OCH₃, -CH(CH₃)₂ oder -C(CH₃)₃.

Ein Indium-Halogen-Alkoxid kann identische bzw. unterschiedliche Reste R aufweisen. Bevorzugt werden für das erfindungsgemäße Verfahren jedoch Indium-Halogen-Alkoxide eingesetzt, die den gleichen Alkyl- bzw. Alkyloxyalkylrest R aufweisen.

Prinzipiell können alle Halogene in dem Indium-Halogen-Alkoxid eingesetzt werden. Ganz besonders gute Ergebnisse werden jedoch erzielt, wenn Indium-Chlor-Alkoxide eingesetzt werden, d.h. wenn X = Cl.

Beste Ergebnisse werden erzielt, wenn das eingesetzte Indium-Halogen-Alkoxid InCl(OMe)₂, InCl(OCH₂CH₂OCH₃), InCl(OEt)₂, InCl(OiPr)₂ oder InCl(OtBu)₂ ist.

Das Indium-Halogen-Alkoxid InX(OR)₂ wird bevorzugt in Anteilen von 0,1 bis 10 Gew.-%, besonders bevorzugt 0,5 bis 6 Gew.-%, ganz besonders bevorzugt 1 bis 5 Gew.-% bezogen auf die Gesamtmasse der Zusammensetzung eingesetzt.

Die Zusammensetzung umfassend das Indium-Halogen-Alkoxid kann dieses gelöst, d.h. dissoziiert bzw. auf molekularer Ebene komplexiert mit Lösemittelmolekülen, oder in flüssiger Phase dispergiert aufweisen.

Das erfindungsgemäße Verfahren eignet sich - in dem Falle, dass nur Indium-haltige Precursoren eingesetzt werden, besonders gut zur Herstellung von In₂O₃-Schichten mit hoher Qualität und guten Eigenschaften. Besonders gute Schichten resultieren, wenn der einzige eingesetzte Precursor ein Indium-Halogen-Alkoxid ist.

Die Zusammensetzung kann jedoch neben dem Indium-Halogen-Alkoxid noch andere Precursoren, bevorzugt Alkoxide und Halogen-Alkoxide anderer Elemente gelöst oder dispergiert aufweisen. Besonders bevorzugt sind Alkoxide und Halogen-Alkoxide von B, Al, Ga, Ge, Sn, Pb, P, Hf, Zn und Sb. Ganz besonders vorteilhaft einsetzbare Alkoxide und Halogen-Alkoxide sind die Verbindungen Ga(OiPr)₃, Ga(OtBu)₃, Zn(OMe)₂, Sn(OtBu)₄. Entsprechend können durch Einsatz dieser Verbindungen Indiumoxid-haltige Schichten, die darüber hinaus die Elemente B, Al, Ga, Ge Sn, Pb, P, Zn und Sb bzw. ihre Oxide aufweisen, hergestellt werden.

Die Zusammensetzung weist weiterhin mindestens ein Lösemittel bzw. Dispersionsmedium auf. Somit kann die Zusammensetzung auch zwei oder mehr Lösemittel bzw. Dispersionsmedien aufweisen. Zur Erzielung besonders guter Indiumoxid-haltiger Schichten sollte jedoch nur ein Lösemittel bzw. Dispersionsmedium in der Zusammensetzung vorliegen.

Bevorzugt einsetzbare Lösemittel bzw. Dispersionsmedien sind aprotische und schwach protische Lösemittel bzw. Dispersionsmedien, d.h. solche ausgewählt aus der Gruppe der aprotischen unpolaren Lösemittel/Dispersionsmedien, d.h. der Alkane, substituierten Alkane, Alkene, Alkine, Aromaten ohne oder mit aliphatischen oder aromatischen Substituenten, halogenierten Kohlenwasserstoffe, Tetramethylsilan, der Gruppe der aprotischen polaren Lösemittel/Dispersionsmedien, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat und der schwach protischen Lösemittel/Dispersionsmedien, d.h. der Alkohole, der primären und sekundären Amine und Formamid. Besonders bevorzugt einsetzbare Lösemittel bzw. Dispersionsmedien sind Alkohole sowie Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, Butylacetat, Ethyllactat, Methoxyethanol, Butoxyethanol, 1-Methoxy-2-Propanol, N-Methyl-2-pyrrolidon (NMP), Tetralin, Ethylbenzoat und Diethylether. Ganz besonders bevorzugte Lösemittel bzw. Dispersionsmedien sind Methanol, Ethanol, Isopropanol, Tetrahydrofurfurylalkohol, tert-Butanol, Butylacetat, Ethyllactat, Methoxyethanol, 1-Methoxy-2-Propanol, und Toluol sowie ihre Gemische. Aufgrund ihrer geringen Toxizität sind die Lösemittel Ethanol, Isopropanol, Tetrahydrofurfurylalkohol, tert-Butanol, Butylacetat, Ethyllactat, 1-Methoxy-2-Propanol und Toluol noch weiter bevorzugt.

Das Lösemittel bzw. Dispersionsmedium wird bevorzugt in Anteilen von 99,9 bis 90 Gew.-% bezogen auf die Gesamtmasse der Zusammensetzung eingesetzt.

Bevorzugt weist die bei dem erfindungsgemäßen Verfahren eingesetzte Zusammensetzung zur Erzielung einer besonders guten Verdruckbarkeit eine Viskosität von 1 mPa·s bis 10 Pa·s, insbesondere 1 mPa·s bis 100 mPa·s bestimmt nach DIN 53019 Teil 1 bis 2 und gemessen bei 20 °C auf. Entsprechende Viskositäten können durch Zugabe von Polymeren, Cellulosederivaten, oder z.B. unter der Handelsbezeichnung Aerosil erhältlichem SiO₂, und insbesondere bevorzugt durch PMMA, Polyvinylalkohol, Urethanverdicker oder Polyacrylatverdicker eingestellt werden.

Bei dem Substrat, das bei dem erfindungsgemäßen Verfahren eingesetzt wird, handelt es sich bevorzugt um ein Substrat bestehend aus Glas, Silicium, Siliciumdioxid, einem Metall- oder Übergangsmetalloxid, einem Metall oder einem polymeren Material, insbesondere PI, PEN, PEEK, PC oder PET.

Das erfindungsgemäße Verfahren ist besonders vorteilhaft ein Beschichtungsverfahren ausgewählt aus Druckverfahren (insbesondere Flexo/Gravur-Druck, Inkjet-Druck - ganz besonders bevorzugt kontinuierlicher, thermischer oder Piezo-Inkjet-Druck -, Offset-Druck, digitalem Offset-Druck und Siebdruck), Sprühverfahren, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating. Ganz besonders bevorzugt ist das erfindungsgemäße Verfahren ein Druckverfahren. Als Druckverfahren eignet sich insbesondere InkJet sowie Flüssigtonerverfahren (wie z.B. HP Indigo), da diese Verfahren sich besonders gut für eine strukturierte Auftragung des Druckmaterials eignet.

Wie bereits ausgeführt, erfolgt die Bestrahlung mit Strahlung mit signifikanten Anteilen von Strahlung im Bereich von 170 - 210 nm und von 250 - 258 nm. Dabei resultieren besonders gute Ergebnisse, wenn die Bestrahlung in Gegenwart von Sauerstoff (O₂) durchgeführt wird. Ganz besonders gute Ergebnisse resultieren, wenn die Bestrahlung in einer Atmosphäre enthaltend 15-25 Vol.-% Sauerstoff erfolgt. Der Einsatz von Sauerstoff hat bei dem erfindungsgemäßen Verfahren den Vorteil, dass durch die gewählten Wellenlängen aus O₂ selektiv atomarer Sauerstoff (O) bzw. Ozon (O₃) erzeugt wird, die mit den organischen Resten des Precursors reagieren und somit die erforderliche Temperatur für die thermische Konvertierung zu einer Indiumoxid-haltigen Schicht einer bestimmten Güte absenken.

Besonders gut lassen sich dabei mit dem erfindungsgemäßen Verfahren strukturierte Halbleiterflächen herstellen, wenn die Bestrahlung in Schritt b) durch eine die entsprechende Struktur vorgebende Maske erfolgt. Der entstehende atomare Sauerstoff reagiert mit bzw. entfernt an den durch die Maske zugänglichen Stellen organische Precursorbestandteile. Die somit selektiv bestrahlten Bereiche sind aufgrund dessen nach dem Tempern widerstandsfähiger gegenüber einer Aufarbeitung als unbestrahlte Bereiche. Die unbestrahlten Bereiche lassen sich nach der Temperierung bereits durch den Einsatz insbesondere schwacher Säuren (besonders bevorzugt 0,1 M Oxalsäure) entfernen. Gegenstand der Erfindung ist somit auch ein entsprechendes Verfahren, bei dem die Bestrahlung in Schritt b) durch eine die entsprechende Struktur vorgebende Maske erfolgt und nach der Temperierung in einem Schritt e) nichtbestrahlte Bereiche durch den Einsatz wässriger Säuren entfernt werden. Besonders bevorzugte Maskentypen sind Kontaktmasken und Schattenmasken. Bei einer Kontaktmaske handelt es sich um eine auf der Probe aufliegenden Maske, die an den Stellen, an denen die Strukturierung erfolgen soll, Aussparungen oder Bereiche dünnerer Materialstärke (insbesondere Löcher) aufweist. Ein besonders bevorzugter Kontaktenmaskentyp ist ein geätztes oder lasergeschnittenes Blech mit Aussparungen, die das finale Layout ergeben. Im Gegensatz zu einer Kontaktmaske wird eine Schattenmaske bei der Strukturierung in einigem Abstand zur Probe eingesetzt. Bevorzugte Schattenmasken bestehen aus Quarzglas, da Quarzglas den Vorteil aufweist, durchlässig für UV-Licht zu sein. Die abgeschatteten Bereiche sind bevorzugt mit Chrom bedampft und verhindern, dass UV-Licht durchgeht. Entsprechende Schattenmasken werden oft auch als Chrom-Glas-Masken bezeichnet. Vorzugsweise werden Schattenmasken und nicht Kontaktmasken eingesetzt, da diese den Vorteil aufweisen, nicht im direkten Kontakt zur Probenoberfläche eingesetzt zu werden.

Das erfindungsgemäße Verfahren zur Herstellung Indiumoxid-haltiger Schichten ist weiterhin prinzipiell gleichermaßen für die Durchführung in An- oder Abwesenheit von Wasser geeignet. Unter Durchführungen "in Gegenwart von Wasser" sind dabei insbesondere Sol-Gel-Verfahren zu verstehen, bei denen der Indiumoxid-Precursor vor Bestrahlung in Gegenwart von Wasser zu einem Gel umgesetzt wird, das dann bestrahlt wird. Bevorzugt, da dies einfacher für die Verfahrensführung ist, wird das erfindungsgemäße Verfahren jedoch nicht als Sol-Gel-Verfahren durchgeführt.

Prinzipiell kann das erfindungsgemäße Verfahren weiterhin in komplett wasserfreier Atmosphäre (d.h. in dieser liegen weniger als 500 ppm Wasser vor) und mit wasserfreien Zusammensetzungen (d.h. solche enthaltend ebenfalls weniger als 500 ppm Wasser) durchgeführt werden oder in/mit entsprechenden wasserhaltigen Atmosphären und Zusammensetzungen. Zur Erzielung besonders guter Ergebnisse, insbesondere zur Erzielung möglichst glatter Oberflächen beträgt die relative Luftfeuchtigkeit nicht mehr als 70 %.

Nach der Beschichtung und Bestrahlung und vor der Konvertierung wird das beschichtete Substrat weiterhin bevorzugt getrocknet. Entsprechende Maßnahmen und Bedingungen hierfür sind dem Fachmann bekannt. Die Trocknung unterscheidet sich von der Konvertierung dadurch, dass bei ihr bei Temperaturen, die im Wesentlichen noch keine Umwandlung des Materials bewirken, das Lösemittel bzw. Dispersionsmedium entfernt wird. Erfolgt die Trocknung auf thermischem Wege, beträgt die Temperatur nicht mehr als 120 °C.

Die abschließende Konvertierung zu einer Indiumoxid-haltigen Schicht erfolgt auf thermischem Wege. Bevorzugt erfolgt die abschließende Konvertierung durch Temperaturen von kleiner als 500 °C und größer als 120 °C. Besonders gute Ergebnisse können jedoch erzielt werden, wenn zur Konvertierung Temperaturen von 150 °C bis 400 °C eingesetzt werden. Verfahren zur Erzielung dieser Temperaturen beruhen bevorzugt auf der Nutzung von Öfen, Heißluft, Heizplatten, IR-Strahlern und Elektronenstrahlern.

Dabei werden typischerweise Konvertierungszeiten von einigen Sekunden bis hin zu mehreren Stunden verwendet.

Die thermische Konvertierung kann weiterhin dadurch unterstützt werden, dass vor, während oder nach der thermischen Behandlung UV-, IR- oder VIS-Strahlung eingestrahlt oder das beschichtete Substrat mit Luft bzw. Sauerstoff behandelt wird.

Die Güte der nach dem erfindungsgemäßen Verfahren erzeugten Schicht kann weiterhin durch eine an den Konvertierungsschritt anschließende kombinierte Temperatur- und Gasbehandlung (mit H₂ oder O₂), Plasmabehandlung (Ar-, N₂-, O₂- oder H₂-Plasma), Laser-Behandlung (mit Wellenlängen im UV-, VIS- oder IR-Bereich) oder eine Ozon-Behandlung weiter verbessert werden.

Der Beschichtungsprozess kann zur Erhöhung der Dicke wiederholt werden. Dabei kann der Beschichtungsprozess dergestalt erfolgen, dass nach jedem einzelnen Auftrag mit elektromagnetischer Strahlung bestrahlt und dann konvertiert wird, oder aber es erfolgen mehrere Auftragungen, an die sich jeweils eine elektromagnetische Bestrahlung anschließt, mit einem einzigen thermischen Konvertierungsschritt nach dem letztem Auftrag.

Gegenstand der Erfindung sind weiterhin die über das erfindungsgemäße Verfahren herstellbaren Indiumoxid-haltigen Schichten. Besonders gute Eigenschaften haben dabei über das erfindungsgemäße Verfahren herstellbare Indiumoxid-haltige Schichten, die reine Indiumoxidschichten sind. Wie bereits zuvor ausgeführt, werden bei ihrer Herstellung nur indiumhaltige Precursoren, bevorzugt nur Indium-Halogen-Alkoxide, besonders bevorzugt nur ein Indium-Halogen-Alkoxid eingesetzt.

Die über das erfindungsgemäße Verfahren herstellbaren Indiumoxid-haltigen Schichten eignen sich vorteilhaft für die Herstellung leitender oder halbleitender Schichten für elektronische Bauteile, insbesondere für die Herstellung von Transistoren (insbesondere Dünnschichttransistoren), Dioden, Sensoren oder Solarzellen.

Die nachfolgenden Beispiele sollen, ohne selbst beschränkend zu wirken, den Gegenstand der vorliegenden Erfindung näher erläutern.

### Beispiel:

### Beispiel (Indiumchloralkoxid als Precursor)

Auf ein dotiertes Siliciumsubstrat mit einer Kantenlänge von etwa 15 mm und mit einer ca. 200 nm dicken Siliciumoxid-Beschichtung und Fingerstrukturen aus ITO/Gold wurden 100 µl einer 1,0 Gew.-% Lösung von InCl(OMe)₂ in Ethanol aufgebracht. Dann erfolgt Spin Coating bei 2000 rpm (5 Sekunden). Das beschichtete Substrat wird direkt nach diesem Beschichtungsvorgang für 5 Minuten mit aus einer Quecksilberdampflampe stammenden UV-Strahlung (Leuchtmittel GLF-100, Jelight 144AX-220, Quarzglas, Jelight) im Wellenlängenbereich von 150 - 300 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit µ_{FET} = 8.5 cm²/Vs bestimmen.

### Vergleichsbeispiel (Indiumalkoxid als Precursor)

Auf ein dotiertes Siliciumsubstrat mit einer Kantenlänge von etwa 15 mm und mit einer ca. 200 nm dicken Siliciumoxid-Beschichtung und Fingerstrukturen aus ITO/Gold wurden 100 µl einer 1,0 Gew.-% Lösung von In(OiPr)₃ in Ethanol aufgebracht. Dann erfolgt Spin Coating bei 2000 rpm (5 Sekunden). Das beschichtete Substrat wird direkt nach diesem Beschichtungsvorgang für 5 Minuten mit aus einer Quecksilberdampflampe stammenden UV-Strahlung (Leuchtmittel GLF-100, Jelight 144AX-220, Quarzglas, Jelight) im Wellenlängenbereich von 150 - 300 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit µ_{FET} = 3,8 cm²/Vs bestimmen.

### Vergleichsbeispiel (Indiumchloralkoxid als Precursor und alternative UV-Quelle)

Auf ein dotiertes Siliciumsubstrat mit einer Kantenlänge von etwa 15 mm und mit einer ca. 200 nm dicken Siliciumoxid-Beschichtung und Fingerstrukturen aus ITO/Gold wurden 100 µl einer 1,0 Gew.-% Lösung von InCl(OMe)₂ in Ethanol aufgebracht. Dann erfolgt Spin Coating bei 2000 rpm (5 Sekunden). Das beschichtete Substrat wird direkt nach diesem Beschichtungsvorgang für 5 Minuten mit aus einer Quecksilberdampflampe stammenden UV-Strahlung (Leuchtmittel GLG-100, Jelight 144AX-220, ozonfrei, Jelight, keine Strahlung bei Wellenlängen <210 nm) im Wellenlängenbereich von 230 - 350 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit µ_{FET} = 4.5 cm²/Vs bestimmen.

## Patentansprüche

1. Flüssigphasen-Verfahren zur Herstellung Indiumoxid-haltiger Schichten, bei dem eine aus einem Gemisch enthaltend mindestens einen Indiumoxid-Precursor und mindestens ein Lösemittel bzw. Dispersionsmedium herstellbare Beschichtungszusammensetzung in der Reihenfolge der Punkte a) bis d)
a) auf ein Substrat aufgebracht,
b) die auf dem Substrat aufgebrachte Zusammensetzung mit elektromagnetischer Strahlung bestrahlt,
c) ggf. getrocknet und
d) thermisch in eine Indiumoxid-haltige Schicht konvertiert wird,
**dadurch gekennzeichnet, dass**
- der Indiumoxid-Precursor ein Indium-Halogen-Alkoxid der generischen Formel InX(OR)₂ mit R = Alkylrest und/oder Alkoxyalkylrest und X = F, Cl, Br oder I ist und
- die Bestrahlung mit elektromagnetischer Strahlung mit signifikanten Anteilen von Strahlung im Bereich von 170 - 210 nm und von 250 - 258 nm durchgeführt wird.

2. Verfahren nach Anspruch 1,
**dadurch gekennzeichnet, dass**
die Bestrahlung mit elektromagnetischer Strahlung mit signifikanten Anteilen von Strahlung im Bereich von 183 - 187 nm und von 250 - 258 nm durchgeführt wird.

3. Verfahren nach Anspruch 1 oder 2,
**dadurch gekennzeichnet, dass**
die Bestrahlung durch Einsatz einer Niederdruck-Quecksilberdampflampe erfolgt.

4. Verfahren nach einem der Ansprüche 1 bis 3,
**dadurch gekennzeichnet, dass**
die Alkyl- bzw. Alkoxyalkylreste des mindestens einen Indium-Halogen-Alkoxids C1-bis C15-Alkoxy- oder Alkyloxyalkylgruppen sind.

5. Verfahren nach einem der vorhergehenden Ansprüche,
**dadurch gekennzeichnet, dass**
das Indium-Halogen-Alkoxid InCl(OMe)₂, InCl(OCH₂CH₂OCH₃)₂, InCl(OEt)₂, InCl(OiPr)₂ oder InCl(OtBu)₂ ist.

6. Verfahren nach einem der vorhergehenden Ansprüche,
**dadurch gekennzeichnet, dass**
das Indium-Halogen-Alkoxid InX(OR)₂ in Anteilen von 0,1 bis 10 Gew.-% bezogen auf die Gesamtmasse der Zusammensetzung eingesetzt wird.

7. Verfahren nach einem der vorhergehenden Ansprüche,
**dadurch gekennzeichnet, dass**
das die Zusammensetzung neben dem Indium-Halogen-Alkoxid noch andere Precursoren, bevorzugt Alkoxide oder Halogen-Alkoxide anderer Elemente, besonders bevorzugt Alkoxide oder Halogen-Alkoxide von B, Al, Ga, Ge, Sn, Pb, P, Hf, Zn und Sb, gelöst oder dispergiert aufweist.

8. Verfahren nach einem der vorhergehenden Ansprüche,
**dadurch gekennzeichnet, dass**
das mindestens eine Lösemittel oder Dispersionsmedium Methanol, Ethanol, Isopropanol, Tetrahydrofurfurylalkohol, tert-Butanol, Butylacetat, Methoxyethanol, 1-Methoxy-2-Propanol oder Toluol ist.

9. Verfahren nach einem der vorherigen Ansprüchen,
**dadurch gekennzeichnet, dass**
das mindestens eine Lösemittel oder Dispersionsmedium in Anteilen von 90 bis 99,9 Gew.-% bezogen auf die Gesamtmasse der Zusammensetzung vorliegt.

10. Verfahren nach einem der vorhergehenden Ansprüche,
**dadurch gekennzeichnet, dass**
die Bestrahlung in Schritt b) in Gegenwart von Sauerstoff (02) durchgeführt wird.

11. Verfahren zur Herstellung strukturierter Indiumoxid-haltiger Schichten nach Anspruch 10,
**dadurch gekennzeichnet, dass**
die Bestrahlung in Schritt b) durch eine die entsprechende Struktur vorgebende Maske erfolgt.

12. Verfahren nach Anspruch 11,
**dadurch gekennzeichnet, dass**
nach der Temperierung in einem Schritt e) nichtbestrahlte Bereiche durch den Einsatz wässriger Säuren entfernt werden.

13. Verfahren nach einem der vorhergehenden Ansprüche,
**dadurch gekennzeichnet, dass**
die Konvertierung thermisch durch Temperaturen kleiner als 500 °C und größer als 120 °C erfolgt.

## Claims

1. Liquid phase process for producing indium oxide-containing layers, in which a coating composition preparable from a mixture comprising at least one indium oxide precursor and at least one solvent and/or dispersion medium, in the sequence of points a) to d),
a) is applied to a substrate, and
b) the composition applied to the substrate is irradiated with electromagnetic radiation,
c) optionally dried and
d) converted thermally into an indium oxide-containing layer,
**characterized in that**
- the indium oxide precursor is an indium halogen alkoxide of the generic formula InX(OR)₂ where R is an alkyl radical and/or alkoxyalkyl radical and X is F, Cl, Br or I and
- the irradiation is carried out with electromagnetic radiation having significant fractions of radiation in the range of 170 - 210 nm and of 250 - 258 nm.

2. Process according to Claim 1,
**characterized in that**
the irradiation is carried out with electromagnetic radiation having significant fractions of radiation in the range of 183 - 187 nm and of 250 - 258 nm.

3. Process according to Claim 1 or 2,
**characterized in that**
the irradiation takes place using a low-pressure mercury vapour lamp.

4. Process according to any of Claims 1 to 3,
**characterized in that**
the alkyl and/or alkoxyalkyl radicals of the at least one indium halogen alkoxide are C1 to C15 alkoxy or alkyloxyalkyl groups.

5. Process according to any of the preceding claims,
**characterized in that**
the indium halogen alkoxide is InCl(OMe)₂, InCl (OCH₂CH₂OCH₃)₂, InCl(OEt)₂, InCl(OiPr)₂ or InCl(OtBu)₂.

6. Process according to any of the preceding claims,
**characterized in that**
the indium halogen alkoxide InX(OR)₂ is used in fractions of 0.1% to 10% by weight, based on the total mass of the composition.

7. Process according to any of the preceding claims,
**characterized in that**
the composition comprises not only the indium halogen alkoxide but also other precursors, preferably alkoxides or halogen alkoxides of other elements, more preferably alkoxides or halogen alkoxides of B, Al, Ga, Ge, Sn, Pb, P, Hf, Zn and Sb, in solution or dispersion.

8. Process according to any of the preceding claims,
**characterized in that**
the at least one solvent or dispersion medium is methanol, ethanol, isopropanol, tetrahydrofurfuryl alcohol, tert-butanol, butyl acetate, methoxyethanol, 1-methoxy-2-propanol or toluene.

9. Process according to any of the preceding claims,
**characterized in that**
the at least one solvent or dispersion medium is present in fractions of 90% to 99.9% by weight, based on the total mass of the composition.

10. Process according to any of the preceding claims,
**characterized in that**
the radiation in step b) is carried out in the presence of oxygen (O2).

11. Process for producing patterned indium oxide-containing layers according to Claim 10,
**characterized in that**
the irradiation in step b) takes place through a mask which ordains the corresponding pattern.

12. Process according to Claim 11,
**characterized in that**
after the heat treatment, in a step e), unirradiated areas are removed through use of aqueous acids.

13. Process according to any of the preceding claims,
**characterized in that**
the converting takes place thermally by temperatures lower than 500°C and higher than 120°C.

## Revendications

1. Procédé en phase liquide pour la fabrication de couches contenant de l'oxyde d'indium, selon lequel une composition de revêtement pouvant être fabriquée à partir d'un mélange contenant au moins un précurseur d'oxyde d'indium et au moins un solvant ou un milieu de dispersion est, dans l'ordre des points a) à d),
a) appliquée sur un substrat,
b) la composition appliquée sur le substrat est exposée à un rayonnement électromagnétique,
c) éventuellement séchée, et
d) convertie thermiquement en une couche contenant de l'oxyde d'indium,
**caractérisé en ce que**
- le précurseur d'oxyde d'indium est un alcoxyde d'indium-halogène de formule générique InX(OR)₂ avec R = radical alkyle et/ou radical alcoxyalkyle et X = F, Cl, Br ou I, et
- l'exposition à un rayonnement électromagnétique est réalisée avec des proportions significatives du rayonnement dans la plage allant de 170 à 210 nm et de 250 à 258 nm.

2. Procédé selon la revendication 1, **caractérisé en ce que** l'exposition à un rayonnement électromagnétique est réalisée avec des proportions significatives du rayonnement dans la plage allant de 183 à 187 nm et de 250 à 258 nm.

3. Procédé selon la revendication 1 ou 2, **caractérisé en ce que** l'exposition à un rayonnement a lieu en utilisant une lampe à vapeur de mercure basse pression.

4. Procédé selon l'une quelconque des revendications 1 à 3, **caractérisé en ce que** les radicaux alkyle ou alcoxyalkyle dudit au moins un alcoxyde d'indium-halogène sont des groupes alcoxy ou alkyloxyalkyle en C1 à C15.

5. Procédé selon l'une quelconque des revendications précédentes, **caractérisé en ce que** l'alcoxyde d'indium-halogène est InCl(OMe)₂, InCl(OCH₂CH₂OCH₃)₂, InCl(OEt)₂, InCl(OiPr)₂ ou InCl(OtBu)₂.

6. Procédé selon l'une quelconque des revendications précédentes, **caractérisé en ce que** l'alcoxyde d'indium-halogène InX(OR)₂ est utilisé en proportions de 0,1 à 10 % en poids, par rapport à la masse totale de la composition.

7. Procédé selon l'une quelconque des revendications précédentes, **caractérisé en ce que** la composition comprend en plus de l'alcoxyde d'indium-halogène encore d'autres précurseurs, de préférence des alcoxydes ou des halogéno-alcoxydes d'autres éléments, de manière particulièrement préférée des alcoxydes ou des halogéno-alcoxydes de B, Al, Ga, Ge, Sn, Pb, P, Hf, Zn et Sb, dissous ou dispersés.

8. Procédé selon l'une quelconque des revendications précédentes, **caractérisé en ce que** ledit au moins un solvant ou milieu de dispersion est le méthanol, l'éthanol, l'isopropanol, l'alcool tétrahydrofurfurylique, le tert-butanol, l'acétate de butyle, le méthoxyéthanol, le 1-méthoxy-2-propanol ou le toluène.

9. Procédé selon l'une quelconque des revendications précédentes, **caractérisé en ce que** ledit au moins un solvant ou milieu de dispersion est présent en proportions de 90 à 99,9 % en poids, par rapport à la masse totale de la composition.

10. Procédé selon l'une quelconque des revendications précédentes, **caractérisé en ce que** l'exposition à un rayonnement à l'étape b) est réalisée en présence d'oxygène (O₂).

11. Procédé de fabrication de couches structurées contenant de l'oxyde d'indium selon la revendication 10, **caractérisé en ce que** l'exposition à un rayonnement à l'étape b) a lieu au travers d'un masque donnant la structure appropriée.

12. Procédé selon la revendication 11, **caractérisé en ce qu'**après le recuit lors d'une étape e), les zones non exposées à un rayonnement sont éliminées en utilisant des acides aqueux.

13. Procédé selon l'une quelconque des revendications précédentes, **caractérisé en ce que** la conversion a lieu thermiquement par des températures inférieures à 500 °C et supérieures à 120 °C.
